# EUROPEAN PATENT APPLICATION

(11) **EP 2 267 764 A1**
(43) Date of publication of application: **29.12.2010**
(21) Application number: 09718527.6
(22) Date of filing: 05.03.2009
(51) Int. Cl.: H01L 21/3065

(54) **PLASMA PROCESSING METHOD**

(30) Priority: 07.03.2008 JP 2008057621
(71) Applicant: ULVAC, INC., Chigasaki-shi Kanagawa 253-8543 (JP)
(72) Inventor: MORIKAWA, Yasuhiro, Susono-shi Shizuoka 410-1231 (JP); SUU, Koukou, Susono-shi Shizuoka 410-1231 (JP); MURAYAMA, Takahide, Susono-shi Shizuoka 410-1231 (JP)
(74) Representative: Albutt, Anthony John
(86) International application number: PCT/JP2009/054205
(87) International publication number: WO 2009/110567

(57) **Abstract**

[Object] To provide a plasma processing method capable of maintaining a uniform in-plane distribution from the start to the end of etching by optimizing etching conditions.

[Solving Means] In a plasma processing method according to the present invention, the process of etching a substrate (W) having a mask pattern formed on a surface thereof by using plasma formed in a vacuum vessel (21) and the process of forming a protective film on a side wall portion of an etching pattern formed on the substrate (W) by sputtering a target material (30) disposed in the vacuum vessel (21) by using the plasma are alternately repeated. In the plasma processing method, a uniform in-plane distribution is maintained over a time period from the start to the end of plasma processing by changing a radius of a magnetic neutral line (25) in accordance with progress of the plasma processing including the etching processing and the processing of forming a protective film for the substrate (W).

## Description

### Technical Field

The present invention relates to a plasma processing method for forming a hole or a deep trench with a high aspect ratio on a surface of a silicon substrate, and more specifically, to a plasma processing method capable of maintaining a uniform in-plane distribution from the start to the end of etching.

### Background Art

Conventionally, a plasma etching (dry etching) method has been widely used for processing of a surface of a silicon substrate. A reaction of atomic (radical) fluorine to silicon at room temperature is spontaneously caused and a relatively high etching rate is obtained. Therefore, in the etching of the silicon substrate, gas containing fluorine, such as SF₆, NF₃, COF₂, and XeF₂, is frequently used as an etching gas.

On the other hand, since dry etching of the silicon substrate in which an etching gas containing fluorine is used is isotropic, the etching also progresses on a side wall portion of an etching pattern (depressed portion) that has been formed. Accordingly, it has been difficult to highly accurately form a fine via with a high aspect ratio, such as a through hole and a deep trench.

In this regard, there has recently been proposed a deep processing technique for a silicon substrate that is capable of, by etching a substrate while forming a protective film on the side wall portion of the etching pattern, suppressing expansion of etching in a lateral direction and maintaining perpendicularity of the side wall portion of the pattern.

For example, Patent Document 1 discloses a method of performing, by alternately repeating an etching process and a protective film forming process, etching while forming a protective film made of a polymer layer on a side wall portion of an etching pattern. Particularly, a sputtering method using an argon gas with respect to a target material arranged opposed to a substrate is disclosed as a deposition method for a protective film.

Since the polymer layer formed on the side wall portion of the etching pattern in the protective film forming process has a smaller removed amount in the etching process than the polymer layer formed on a bottom portion of the etching pattern, the polymer layer formed on the side wall portion of the pattern functions as a protective film and thus anisotropic etching that limits an etching direction to a depth direction of the pattern can be realized.

Patent Document 1: WO2006/003962

### Disclosure of the Invention

### Problem to be solved by the Invention

In recent years, it has been required to increase accuracy of a deep processing technique for a silicon substrate along with achievement of miniaturization and precision of electronic components. In the deep processing technique, generally, there are optimum etching conditions corresponding to a depth of an etching pattern. Further, optimum etching conditions are different between an inner circumferential side and an outer circumferential side of a substrate surface. Accordingly, in a case where etching conditions are fixed in a time period from the start to the end of etching, it is difficult to uniformly etch the substrate surface in the plane. Therefore, there arises a problem that an etching pattern with high accuracy is difficult to be obtained.

In view of the circumstances as described above, it is an object of the present invention to provide a plasma processing method capable of maintaining a uniform in-plane distribution from the start to the end of etching by optimizing etching conditions.

### Means for solving the Problem

In order to achieve the object described above, according to an embodiment of the present invention, there is provided a plasma processing method including generating plasma of gas introduced into a vacuum vessel by forming a high-frequency electric field along a ring-shaped magnetic neutral line formed in the vacuum vessel. A substrate having a mask pattern formed on a surface thereof by using the plasma is etched in the vacuum vessel. A protective film is formed on a side wall portion of an etching pattern formed on the substrate by sputtering a target material disposed in the vacuum vessel by using the plasma. A radius of the magnetic neutral line is changed in accordance with progress of plasma processing including etching processing and processing of forming the protective film for the substrate.

Further, according to another embodiment of the present invention, there is provided a plasma etching method including: generating plasma of gas introduced into a vacuum vessel by forming a high-frequency electric field along a ring-shaped magnetic neutral line formed in the vacuum vessel; etching a substrate having a mask pattern formed on a surface thereof by using the plasma in the vacuum vessel; forming a protective film on a side wall portion of an etching pattern formed on the substrate by sputtering a target material disposed in the vacuum vessel by using the plasma; and changing a radius of the magnetic neutral line in accordance with progress of the etching for the substrate.

### Best Mode for Carrying Out the Invention

According to an embodiment of the present invention, there is provided a plasma processing method including generating plasma of gas introduced into a vacuum vessel by forming a high-frequency electric field along a ring-shaped magnetic neutral line formed in the vacuum vessel. A substrate having a mask pattern formed on a surface thereof by using the plasma is etched in the vacuum vessel. A protective film is formed on a side wall portion of an etching pattern formed on the substrate by sputtering a target material disposed in the vacuum vessel by using the plasma. A radius of the magnetic neutral line is changed in accordance with progress of plasma processing including etching processing and processing of forming the protective film for the substrate.

The plasma processing method is applied to an NLD (magnetic Neutral Loop Discharge) plasma etching method. The magnetic neutral loop discharge is technology of forming plasma by applying a high-frequency electric field along a ring-shaped magnetic neutral line having a zero magnetic field that is formed in the vacuum vessel. The magnetic neutral line can be formed by, for example, a plurality of magnetic coils disposed around the vacuum vessel, and a radius, position, or the like of the magnetic neutral line can be adjusted arbitrarily by an amount of a current that flows into each of those magnetic coils.

In the plasma processing method, a density distribution of the plasma generated in the vacuum vessel is changed by adjusting the radius of the magnetic neutral line in accordance with the progress of the plasma processing for the substrate. The phrase "in accordance with the progress of the plasma processing" includes the meanings of "in accordance with a depth of an etching pattern", "in accordance with an etching process or sputtering process", and the like. Further, the phrase "in accordance with progress of etching" includes the meanings of "in accordance with a depth of an etching pattern", "in accordance with an etching process or sputtering process", and the like.

As described above, since an optimum etching environment corresponding to an in-plane distribution of an etching rate that changes in accordance with the progress of the plasma processing can be obtained, a uniform in-plane distribution can be maintained over a time period from the start to the end of etching.

Further, in the plasma processing method, the process of etching a substrate and the process of forming a protective film may be alternately repeated. The process of adjusting a radius of the magnetic neutral line includes changing the radius of the magnetic neutral line in a stepwise manner during a time period from a start to an end of the plasma processing.

As described above, by sectioning the time period from the start to the end of etching into a plurality of stages and changing the radius of the magnetic neutral line so as to suit an optimum process condition that has been evaluated in advance in each stage, it is possible to perform etching that is excellent in in-plane uniformity over the time period from the start to the end of etching. The number of sectioned stages is not particularly limited, but with a larger number of stages, highly accurate etching processing can be realized.

In the plasma processing method, the process of changing a radius of the magnetic neutral line can be executed in the process of etching a substrate. Accordingly, the etching processing that is excellent in in-plane uniformity for a substrate can be performed.

Further, in the plasma processing method, the process of changing a radius of the magnetic neutral line may be executed in the process of forming a protective film. Accordingly, an etching protective film that is excellent in in-plane uniformity can be formed.

In addition, a pressure of the gas introduced into the vacuum vessel can be changed in accordance with the progress of the plasma processing for the substrate. For example, as the etching pattern becomes deeper, the pressure is reduced and the directivity of an etchant to a bottom portion of the pattern is enhanced, with the result that it is possible to realize appropriate etching processing toward a depth direction. This method is also applicable to the protective film forming process similarly.

Further, a mixing ratio of a gas mixture introduced into the vacuum vessel can be changed in accordance with the progress of the plasma processing for the substrate. Accordingly, the etching processing that is appropriate for the depth of the etching pattern can be performed. This method is also applicable to the protective film forming process similarly.

Further, a strength of the high-frequency electric field can be changed in accordance with the progress of the plasma processing for the substrate. Accordingly, since a plasma density can be controlled, it is possible to optimize plasma forming conditions in combination with the control of the radius of the magnetic neutral line.

Hereinafter, an embodiment of the present invention will be described with reference to the drawings.

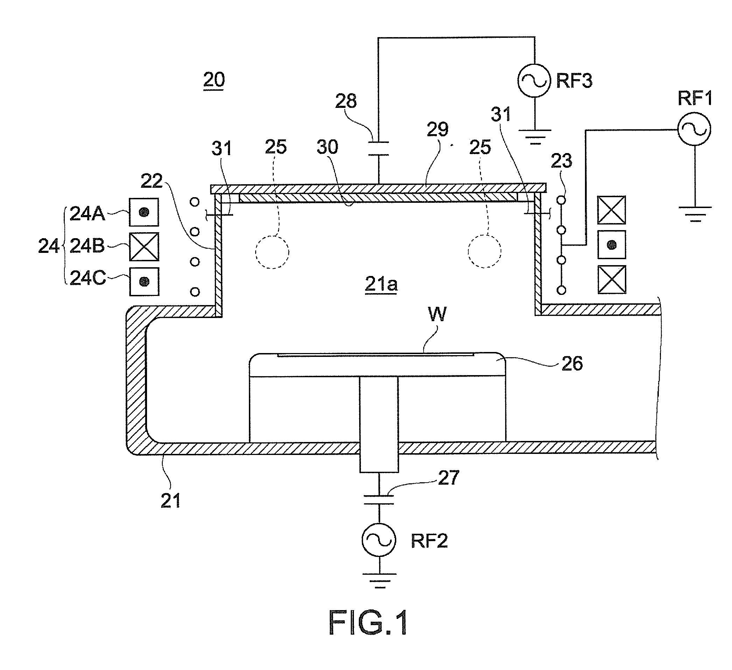

Fig. 1 is a schematic structural diagram of a plasma etching apparatus 20 that is applied to a plasma processing method according to an embodiment of the present invention. The plasma etching apparatus 20 shown in the figure is constituted as an NLD (magnetic Neutral Loop Discharge) plasma etching apparatus and has a function of etching a substrate surface and a function of forming a protective film on a side wall portion of an etching pattern of the substrate surface.

In Fig. 1, a vacuum vessel is represented by reference numeral 21, in which a vacuum chamber (plasma chamber) including a plasma forming space 21a is formed. A vacuum pump such as a TMP (Turbo Molecular Pump) is connected to the vacuum vessel 21, and an inside of the vacuum vessel 21 is evacuated to a predetermined degree of vacuum.

A circumference of the plasma forming space 21a is partitioned with a cylindrical wall 22 constituting a part of the vacuum vessel 21. The cylindrical wall 22 is constituted of a transparent insulating material such as quartz. Arranged on an outer circumferential side of the cylindrical wall 22 are a high-frequency coil (antenna) 23 for generating plasma, which is connected to a first high-frequency power source RF1, and a magnetic coil group 24 of three magnetic coils (24A, 24B, and 24C) arranged on an outer circumferential side of the high-frequency coil 23.

The magnetic coil 24A and the magnetic coil 24C are each supplied with a current in the same direction and the magnetic coil 24B is supplied with a current in a direction opposite to that of the other magnetic coils 24A and 24C. As a result, a magnetic neutral line 25 in which a magnetic field is zero is continuously formed in a ring shape in the plasma forming space 21a. Then, by an induction electric field (high-frequency electric field) formed by the high-frequency coil 23 along the magnetic neutral line 25, discharge plasma is generated.

Particularly, in the NLD plasma etching apparatus, a formation position and a size (radius) of the magnetic neutral line 25 can be adjusted depending on an amount of a current that flows into each of the magnetic coils 24A to 24C. That is, when a current that flows into each of the magnetic coils 24A, 24B, and 24C is represented by I_{A}, I_{B}, and I_{C}, respectively, the formation position of the magnetic neutral line 25 is lowered toward the magnetic coil 24C side in a case of I_{A} > I_{C}, and conversely, the formation position of the magnetic neutral line 25 is raised toward the magnetic coil 24A side in a case of I_{A} < I_{C}. Further, when an amount of the current I_{B} that flows into the intermediate magnetic coil 24B is increased, a ring diameter of the magnetic neutral line 25 becomes small, and when the current I_{B} is reduced, the ring diameter of the magnetic neutral line 25 becomes large. In addition, a magnetic field gradient of the magnetic neutral line 25 at a position where the magnetic field is zero can be controlled by the amount of the current I_{B}. The magnetic field gradient becomes gentler as I_{B} becomes larger, and becomes steeper as I_{B} is more reduced. By utilizing those characteristics, it is possible to achieve optimization of a plasma density distribution.

On the other hand, a stage 26 that supports a semiconductor wafer (silicon (Si) substrate) W is disposed inside the vacuum vessel 21. The stage 26 has a structure including a conductor and is connected to a second high-frequency power source RF2 via a capacitor 27. It should be noted that the stage 26 incorporates a heat source such as a heater for heating the substrate W to a predetermined temperature.

A top panel 29 is disposed at an upper portion of the plasma forming space 21a. The top panel 29 is constituted as a counter electrode of the stage 26 and connected to a third high-frequency power source RF3 via a capacitor 28. On a surface of the top panel 29 on the plasma forming space 21a side, a target material (sputtering target) 30 for forming a film on a substrate by sputtering is attached. Though a fluorine-based resin such as polytetrafluoroethylene (PTFE) is used as the target material 32 in this embodiment, any other synthetic resin materials, silicon materials, carbon materials, silicon carbide materials, silicon oxide materials, silicon nitride materials, and the like are applicable.

In the vicinity of the top panel 29, a gas introduction member 31 for introducing a process gas into the vacuum vessel 21 is disposed. In this embodiment, the process gas includes an etching process gas and a sputtering process gas.

As the etching gas, at least one of SF₆, NF₃, SiF₄, and XeF₂ or a gas mixture with an inert gas is used. As the gas mixture, a gas mixture including two or more gases, such as SF₆/Ar and HBr/SF₆/O₂, can be used. In this embodiment, the gas mixture of SF₆/Ar is used as an etching gas.

On the other hand, as the process gas for sputtering, a noble gas or an inert gas such Ar and N₂ can be used. In this embodiment, Ar is used as a process gas for sputtering.

In the plasma etching apparatus 20 of this embodiment, by alternately repeating an etching process and a protective film forming process with respect to the substrate W placed on the stage 26, a via constituted of a hole or a deep trench with a high aspect ratio, or the like is formed on the surface of the substrate W.

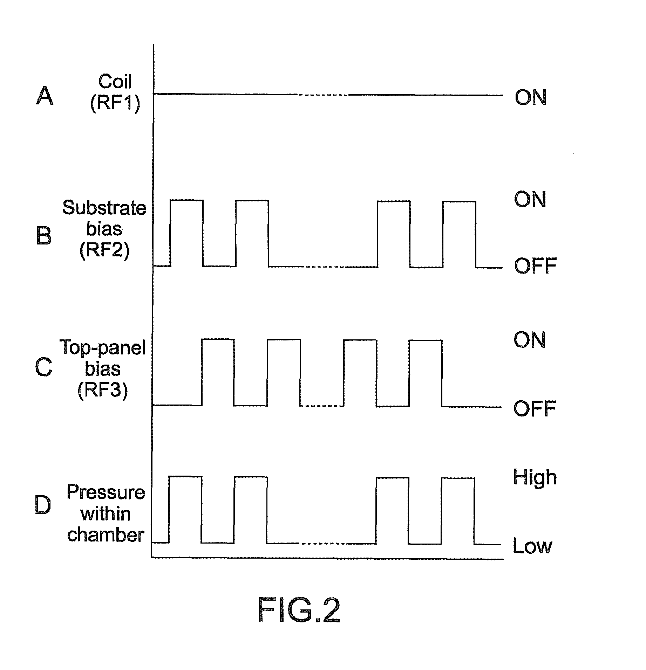

Figs. 2 are timing charts each showing an operation example of the plasma etching apparatus 20 of this embodiment. Fig. 2A shows a power application timing of the first high-frequency power source RF1 that is supplied to the high-frequency coil 23. Fig. 2B shows a power application timing of the second high-frequency power source RF2 that is supplied to the stage 26. Fig. 2C shows a power application timing of the third high-frequency power source RF3 that is supplied to the top panel 29. Fig. 2D shows a pressure change inside the vacuum vessel 21. In this example, a processing pressure (introduction amount of process gas) of the etching process is set to be higher than that of the protective film forming process.

On the surface of the substrate W, a mask pattern is formed in advance. Examples of the mask pattern include an etching mask such as an organic resist and a metal mask. In the etching process and the protective film forming process, in the plasma forming space 21a, the ring-shaped magnetic neutral line 25 is formed by the magnetic coil group 24 and inductively-coupled plasma is also formed along the ring-shaped magnetic neutral line 25 due to power input to the high-frequency coil 23 from the first high-frequency power source RF1.

In the etching process, the etching gas (gas mixture of SF₆ and Ar) introduced into the vacuum vessel 21 is changed into plasma in the plasma forming space 21a, and the substrate W on the stage 26 is subjected to etching processing by generated ions and radicals. At this time, a substrate bias is turned ON due to power input from the second high-frequency power source RF2, the ions are accelerated to the stage 26 side, and radical products on the substrate W are removed by sputtering, to thereby increase etching property. In other words, fluorine radicals react with silicon to form radical products, and the radical products are removed by a sputtering effect due to the ions in the plasma, with the result that the etching processing of the silicon substrate W progresses.

On the other hand, after performing the etching process for a predetermined time period, the etching gas remaining inside the vacuum vessel 21 is exhausted. Then, the process gas for forming a protective film (Ar) is introduced into the vacuum vessel 21 and the protective film forming process is thus started. The introduced process gas is changed into plasma in the plasma forming space 21a. At this time, the substrate bias (RF2) is turned OFF and a top-panel bias is turned ON due to power input from the third high-frequency power source RF3 instead. As a result, the target material 30 disposed on the top panel 29 is sputtered by the ions in the plasma, and the sputtered materials adhere to the surface of the substrate W and the etching pattern formed in the etching process described above. In this way, a polymer layer functioning as a protective film is formed on a bottom portion and side wall portion of the etching pattern.

Here, sputtered particles that are beat out from the target material 30 pass through NLD plasma formed in the plasma forming space 21a to reach the substrate. At this time, by being decomposed and re-excited in a high-density plasma region in which the magnetic neutral line 25 is formed, the sputtered particles isotropically enter the surface of the substrate in a deposition mode similar to a chemical vapor deposition method (CVD method). Accordingly, a step coating film (protective film) of the etching pattern obtained by this embodiment has high coverage property and excellent in-plane uniformity.

It should be noted that by using a gas mixture of Ar and a fluorocarbon-based gas (C₄F₈, CHF₃, or the like) as a process gas of the protective film forming process, a reaction gas in the process gas is changed into plasma in the plasma forming space 21a and radical products thereof are deposited on the substrate surface, with the result that a polymer layer functioning as a protective film can be formed. Further, by using the gas mixture described above as a process gas, it is possible to increase a sputtering rate as compared to a case of using only an Ar gas as a process gas.

After the protective film forming process is performed for a predetermined time period, the etching process described above is performed again. An initial stage of this etching process is spent on an operation of removing the protective film that covers a bottom portion of the etching pattern. After that, the etching processing for the bottom portion of the etching pattern that is exposed by removing the protective film is restarted. At this time, the ions in the plasma enter the substrate in a vertical direction due to the substrate bias effect. So, the ions that reach the protective film that covers the side wall portion of the etching pattern are less than the ions that reach the bottom portion of the etching pattern. Accordingly, during the etching process, the protective film covering the side wall portion of the etching pattern is left without being removed completely. Thus, contact between the side wall portion of the etching pattern and the fluorine radicals is avoided, and erosion caused by etching on the side wall portion of the etching pattern is avoided.

Hereinafter, by alternately repeating the etching process and the protective film forming process described above, anisotropic etching in the vertical direction with respect to the substrate surface is realized. As described above, a via (contact hole or trench) with a high aspect ratio is manufactured inside the substrate W.

Incidentally, it is important to ensure the in-plane uniformity of the plasma processing performed on the surface of the substrate when the surface of the substrate is subjected to etching or sputtering deposition. This becomes conspicuous as a size of the substrate becomes larger. The in-plane uniformity strongly depends on a position of the plasma formed in the vacuum vessel, that is, a density distribution. In the magnetic neutral loop discharge (NLD), high-density plasma is formed at a position where the magnetic neutral line is formed. Accordingly, when a radius of the magnetic neutral line is changed, the density distribution of the plasma generated in the vacuum vessel becomes variable. In this embodiment, the radius of the magnetic neutral line 25 can be adjusted based on an amount of a current supplied to the magnetic coil 24B positioned at the center of the magnetic coil group 24.

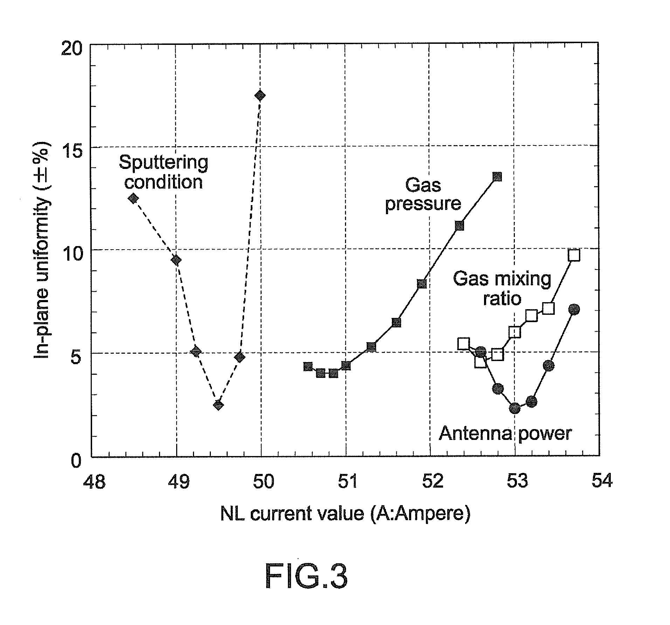

Further, the position where the plasma is formed has a great influence on the in-plane uniformity also depending on a sputtering condition, an etching condition, and the like. As an example thereof, Fig. 3 shows a relationship between the plasma forming position and the in-plane uniformity of the substrate regarding each of a sputtering condition, a pressure of an introduced gas, a mixing ratio of the introduced gas, and an antenna power (RF1).

In Fig. 3, an "NL current value" of the horizontal axis indicates an amount of a current to be supplied to the magnetic coil 24B positioned at the center of the magnetic coil group 24 (Fig. 1). The radius of the magnetic neutral line 25 becomes smaller as this current value becomes larger, and the radius of the magnetic neutral line 25 becomes larger as the current value becomes smaller. In the figure, the "sputtering condition" includes various parameters of a gas pressure, a gas mixing ratio, an antenna power (RF1), a top-panel bias power (RF3), and the like. It should be noted that each of "sputtering condition", "gas pressure", "gas mixing ratio", and "antenna power" of Fig. 3 is a fixed value, and Fig. 3 shows a relationship between the NL current value and the in-plane uniformity with respect to those fixed values.

As shown in Fig. 3, the sputtering condition, gas pressure, gas mixing ratio, antenna power, and the like are largely related with the in-plane uniformity. Though not shown in the figure, the same holds true for the etching condition. Accordingly, in the sputtering processing and the etching processing, it is necessary to set an optimum density of a plasma distribution from the viewpoint of ensuring desired in-plane uniformity.

In this regard, in this embodiment, the radius of the magnetic neutral line 25 is changed in accordance with the progress of etching (plasma processing) performed on the substrate W. For example, in a case where the center portion of the substrate has a higher etching rate than a circumferential portion thereof, the radius of the magnetic neutral line is made large to increase the in-plane uniformity of the etching rate.

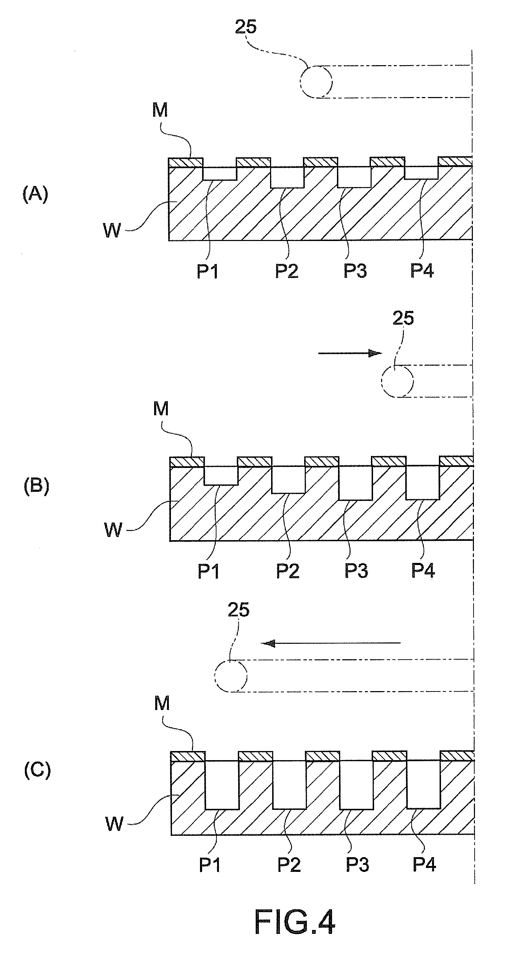

For example, as shown in Figs. 4(A) to (C), in a case where partial etching patterns P2 and P3 on the substrate W have an etching rate higher than an etching pattern P1 on an outer circumferential side thereof or an etching pattern P4 on an inner circumferential side thereof, the radius of the magnetic neutral line 25 is changed at an appropriate timing. In this case, by making the radius of the magnetic neutral line 25 small or large, it is possible to match the etching rate of the patterns P1 and P4 to that of the patterns P2 and P3. It should be noted that in Figs. 4, reference symbol M is an etching mask pattern that is formed on the surface of the substrate W.

As the method described above, the control to change the radius of the magnetic neutral line 25 through multiple steps in one etching process may be adopted, or the control to change the radius of the magnetic neutral line 25 each time the sputtering process is switched to the etching process may be adopted. Further, the change of the radius of the magnetic neutral line 25 is not limited to the control to change the radius in a radius size set in advance through multiple steps, and includes control to successively change the radius within a range of a radius size set in advance.

Other control examples in which the radius of the magnetic neutral line 25 is changed in accordance with the progress of etching (plasma processing) for the substrate W include control to change a position where the magnetic neutral line is formed, between the etching process and the sputtering process. This is because the plasma forming positions at which desired in-plane uniformity can be ensured are different between the etching process and the sputtering process in some cases. In this case, an optimum value of the radius (NL current value) of the magnetic neutral line in each of the etching process and the sputtering process is acquired in advance, and the radius of the magnetic neutral line is changed to a corresponding optimum value at a time when the etching process and the sputtering process are switched to each other. Accordingly, the desired in-plane uniformity can be ensured at a time of the etching processing and the sputtering processing.

On the other hand, since an in-plane distribution of an etching rate is changed in accordance with the depth of the etching pattern, the radius of the magnetic neutral line can be changed in accordance with the in-plane distribution of the etching rate. Accordingly, it is possible to provide an optimum density of the plasma distribution, which corresponds to the depth of the etching pattern and is excellent in in-plane uniformity. Further, a height position and magnetic field gradient of the magnetic neutral line may be changed as appropriate.

As described above, by sectioning the time period from the start to the end of etching into a plurality of stages and changing the radius of the magnetic neutral line so as to suit an optimum process condition that has been evaluated in advance in each stage, it is possible to perform etching that is excellent in in-plane uniformity over the time period from the start to the end of etching (plasma processing). The number of sectioned stages is not particularly limited, but with a larger number of stages, highly accurate etching processing can be realized.

In addition to the radius control of the magnetic neutral line 25 as described above, by also changing parameters described below, it is possible to increase the in-plane uniformity of etching.

### (Gas pressure)

A pressure of gas to be introduced into the vacuum vessel 21 is changed in a stepwise manner over a time period from the start to the end of etching (plasma processing). For example, the control to set a gas pressure to be relatively high at a time when etching is started and reduce the gas pressure in accordance with the progress of the etching can be adopted.

In general, in the deep etching for a silicon substrate, etching at an opening portion of an etching pattern also progresses as the pattern becomes deeper, so it is difficult to maintain accuracy of the form of the opening portion of the pattern. So, by reducing the gas pressure in accordance with the progress of etching, it is possible to strengthen a directivity of ions toward a bottom portion of the pattern and strengthen etching anisotropy in a vertical direction of the substrate. Accordingly, deep processing that is excellent in accuracy of the form of the opening portion of the pattern can be realized.

It should be noted that the control of a gas pressure can be performed in each of the etching process and the sputtering process.

### (Gas mixing ratio)

A mixing ratio of an etching gas (SF₆/Ar) to be introduced into the vacuum vessel 21 is changed over a time period from the start to the end of etching (plasma processing). For example, an Ar amount in the etching gas is increased in accordance with the progress of etching.

Since a relatively high etching rate is obtained in the deep etching for a silicon substrate, a fluorine-based gas such as SF₆ is frequently used as an etching gas. However, since silicon etching using the fluorine-based gas has strong isotropy, the deterioration in accuracy of the form at the opening portion of the pattern or a decrease of an amount of ions that reach the bottom portion of the pattern become apparent as the pattern becomes deeper. So, it is possible to ensure a desired etching rate by increasing an Ar content in the gas in accordance with the progress of etching to increase an amount of ions heading for the bottom portion of the pattern, and effectively prevent the accuracy of the form of the opening portion of the pattern from being deteriorated.

### (Antenna power)

Over the time period from the start to the end of etching (plasma processing), an intensity of the plasma formed along the magnetic neutral line 25 is changed by controlling an antenna power in a stepwise manner.

As described above, the distribution density of the plasma has a great influence on the in-plane uniformity of the substrate. The distribution density of the plasma is largely related with not only the size of the radius of the magnetic neutral line 25 but also the antenna power that generates the plasma, that is, an amount of high-frequency power (RF1) applied to the high-frequency coil 23. Accordingly, by adjusting the amount of the antenna power as appropriate in addition to the radius control of the magnetic neutral line 25, it is possible to further increase the uniformity of an in-plane distribution and also easily realize the in-plane uniformity control.

Since the antenna power and an amount of etching species have a substantially proportional relationship, in a case where the antenna power is fixed, erosion of the opening portion of the pattern also tends to be conspicuous along with the progress of etching. So, by reducing the antenna power in accordance with the progress of etching, it is possible to maintain a predetermined etching effect with respect to the bottom portion of the pattern while reducing an etching damage to the opening portion of the pattern. Further, if a bias power (RF2) applied to the stage 26 is raised in accordance with the progress of etching, the amount of ions that reach the bottom portion of the pattern is increased, with the result that a significant lowering of the etching rate can be avoided.

Though the embodiment of the present invention has been described up to here, the present invention is not limited to the embodiment described above and various modifications can be added thereto without departing from the gist of the present invention.

For example, the control parameters that are changed in a stepwise manner in accordance with the progress of etching (plasma processing) can be applied to not only the antenna power, the pressure of an introduced gas, and the gas mixing ratio described above but also the bias power (RF2) applied to the stage 26 and the bias power (RF3) applied to the top panel 29. For example, in the former case, the bias power (RF2) is increased in accordance with the progress of etching. Accordingly, an effect of attracting ions to the bottom portion of the pattern is enhanced, and a high etching rate can be ensured. Brief Description of Drawings

[Fig. 1] A schematic structural diagram of a plasma etching apparatus used in an embodiment of the present invention.
[Figs. 2] Timing charts for explaining an operation example of the plasma etching apparatus shown in Fig. 1.
[Fig. 3] A diagram showing an example of a relationship between a plasma forming position and in-plane uniformity of a substrate regarding a sputtering condition and the like.
[Figs. 4] Cross-sectional diagrams of a main part, schematically showing an example of an operation of a plasma etching method according to the present invention.

Description of Symbols
- 20: plasma etching apparatus
- 21: vacuum vessel
- 23: high-frequency coil (antenna)
- 24: magnetic coil group
- 25: magnetic neutral line
- 26: stage
- 29: top panel
- 30: target material
- 31: gas introduction member
- W: substrate

## Claims

1. A plasma processing method, comprising:
generating plasma of gas introduced into a vacuum vessel by forming a high-frequency electric field along a ring-shaped magnetic neutral line formed in the vacuum vessel;
etching a substrate having a mask pattern formed on a surface thereof by using the plasma in the vacuum vessel;
forming a protective film on a side wall portion of an etching pattern formed on the substrate by sputtering a target material disposed in the vacuum vessel by using the plasma; and
changing a radius of the magnetic neutral line in accordance with progress of plasma processing including etching processing and processing of forming the protective film for the substrate.

2. The plasma processing method according to claim 1,
wherein the process of etching a substrate and the process of forming a protective film are alternately repeated, and
wherein the process of changing a radius of the magnetic neutral line includes changing the radius of the magnetic neutral line in a stepwise manner during a time period from a start to an end of the plasma processing.

3. The plasma processing method according to claim 2,
wherein the process of changing a radius of the magnetic neutral line is executed in the process of etching a substrate.

4. The plasma processing method according to claim 2,
wherein the process of changing a radius of the magnetic neutral line is executed in the process of forming a protective film.

5. The plasma processing method according to claim 1, further comprising
changing a pressure of the gas in accordance with the progress of the plasma processing for the substrate.

6. The plasma processing method according to claim 1,
wherein the gas is a gas mixture of two or more gases,
the plasma processing method further comprising
changing a mixing ratio of the gases in accordance with the progress of the plasma processing for the substrate.

7. The plasma processing method according to claim 1, further comprising
changing a strength of the high-frequency electric field in accordance with the progress of the plasma processing for the substrate.
